# EUROPEAN PATENT APPLICATION

(11) **EP 4 614 557 A1**
(43) Date of publication of application: **10.09.2025**
(21) Application number: 23890547.5
(22) Date of filing: 30.10.2023
(51) Int. Cl.: H01L 23/04, H01L 23/31, H01L 25/16, H01L 25/18, H01L 23/49, H01L 23/488

(54) **POWER MODULE AND DEVICE**

(30) Priority: 17.11.2022 CN 202211458029; 17.11.2022 CN 202211442180; 17.11.2022 CN 202223090111 U
(71) Applicant: Hisense Home Appliances Group Co., Ltd., Foshan, Guangdong 528303 (CN)
(72) Inventor: ZHOU, Wenjie, Foshan, Guangdong 528303 (CN); CHENG, Zhangming, Foshan, Guangdong 528303 (CN); LI, Zhengkai, Foshan, Guangdong 528303 (CN); BIE, Qingfeng, Foshan, Guangdong 528303 (CN); XIE, Dilin, Foshan, Guangdong 528303 (CN)
(74) Representative: Casalonga
(86) International application number: PCT/CN2023/127842
(87) International publication number: WO 2024/104111

(57) **Abstract**

A power module, comprising a package, a power chip and a control chip that are located in the package, and a power pin and a control pin respectively led from first and second side surfaces of the package that are opposite to each other. The power chip is electrically connected to the control chip, the power pin is electrically connected to the power chip, and the control pin is electrically connected to the control chip. The package comprises a flow guide portion located at at least one corner thereof and configured to implement a resin flow guide function, so as to prevent the package from generating a gap at the corner.

## Description

This application claims priority to Chinese Patent Application No. 202211458029.5, filed on November 17, 2022; Chinese Patent Application No. 202211442180.X, filed on November 17, 2022; and Chinese Patent Application No. 202223090111.5, filed on November 17, 2022, which are incorporated herein by reference in their entireties.

### TECHNICAL FIELD

The present disclosure relates to the technical field of electronic devices, and in particular, to a power module and a device.

### BACKGROUND

Power modules (PM) have characteristics of high current density, low saturation voltage, low driving power, high switching frequency, high functional integration level, convenience of use and good reliability. The power modules may be widely applied to many fields such as consumer electronics, household appliances, automobiles, rail transit, industrial equipment, new and renewable sources of energy, smart grid, etc. Generally, the power module uses a resin to package power chips and control chips, so that the characteristic of a high integration level of the power module may be achieved.

### SUMMARY

In an aspect, a power module is provided. The power module includes a packaging body, a power chip and a control chip disposed in the packaging body, a power pin led out from a first side of the packaging body, and a control pin led out from a second side of the packaging body. The power chip is electrically connected to the control chip, the power pin is electrically connected to the power chip, and the control pin is electrically connected to the control chip. The first side and the second side are disposed opposite to each other. The packaging body includes a flow guide portion located at at least one corner of the packaging body, and the flow guide portion is configured to guide a resin to flow, so as to avoid a gap at the corner in the packaging body.

In another aspect, a device is provided. The device includes a controller and the power module provided in the embodiments. The power module is connected to the controller.

### BRIEF DESCRIPTION OF THE DRAWINGS

FIG. 1A is a schematic diagram showing a structure of a main structure of a power module packaged by transfer molding in the related art;
FIG. 1B is a perspective view of a power module in the related art;
FIG. 2 is a perspective view of a power module, in accordance with some embodiments;
FIG. 3 is a perspective view of a power module, in accordance with some embodiments;
FIG. 4 is a perspective view of a power module, in accordance with some embodiments;
FIG. 5 is a perspective view of a power module, in accordance with some embodiments;
FIG. 6 is a top view of a power module, in accordance with some embodiments;
FIG. 7 is a top view of a power module, in accordance with some embodiments;
FIG. 8 is a bottom view of a power module, in accordance with some embodiments;
FIG. 9 is a top view of a power module, in accordance with some embodiments;
FIG. 10 is a partial enlarged view of the power module in FIG. 9;
FIG. 11A is a schematic diagram showing a structure of a main structure of a power module packaged by transfer molding, in accordance with some embodiments;
FIG. 11B is a schematic sectional view of a power module taken along a width direction, in accordance with some embodiments;
FIG. 11C is a schematic sectional view of a power module taken along a width direction, in accordance with some embodiments;
FIG. 11D is a schematic sectional view of a power module taken along a width direction, in accordance with some embodiments;
FIG. 11E is a schematic sectional view of a power module taken along a width direction, in accordance with some embodiments;
FIG. 12 is a side view of a power module, in accordance with some embodiments;
FIG. 13 is a sectional view of a power module, in accordance with some embodiments;
FIG. 14 is a partial enlarged view of the region D1 of the power module in FIG. 13;
FIG. 15 is a partial enlarged view of the region D2 of the power module in FIG. 13;
FIG. 16 is a partial enlarged view of the region D3 of the power module in FIG. 13;
FIG. 17 is a top view of a power module, in accordance with some embodiments;
FIG. 18 is a partial enlarged view of the region A1 of the power module in FIG. 17;
FIG. 19 is a sectional view of a power module, in accordance with some embodiments;
FIG. 20 is a partial enlarged view of the region B1 of the power module in FIG. 19;
FIG. 21 is a partial enlarged view of the region B1 of the power module in FIG. 19; and
FIG. 22 is a schematic diagram showing a structure of a device, in accordance with some embodiments.

### DETAILED DESCRIPTION

Some embodiments of the present disclosure will be described clearly and completely with reference to the accompanying drawings. However, the described embodiments are merely some but not all embodiments of the present disclosure. All other embodiments obtained by a person of ordinary skill in the art based on embodiments of the present disclosure shall be included in the protection scope of the present disclosure.

Hereinafter, the terms "first" and "second" are used for descriptive purposes only, and are not to be construed as indicating or implying a relative importance or implicitly indicating the number of indicated technical features. Thus, a feature defined with "first" or "second" may explicitly or implicitly include one or more of the features.

The phrase "A and/or B" includes following three combinations: only A, only B, and a combination of A and B.

Exemplary embodiments are described herein with reference to sectional views and/or plan views as idealized exemplary drawings. In the accompanying drawings, thicknesses of layers and regions are enlarged for clarity. The exemplary embodiments of the present disclosure should not be construed as being limited to the shapes of the regions shown herein, but including shape deviations due to, for example, manufacturing. For example, an etched region shown to have a rectangular shape generally has a curved feature. Therefore, the regions shown in the accompanying drawings are schematic in nature, and their shapes are not intended to show actual shapes of the regions in devices, and are not intended to limit the scope of the exemplary embodiments.

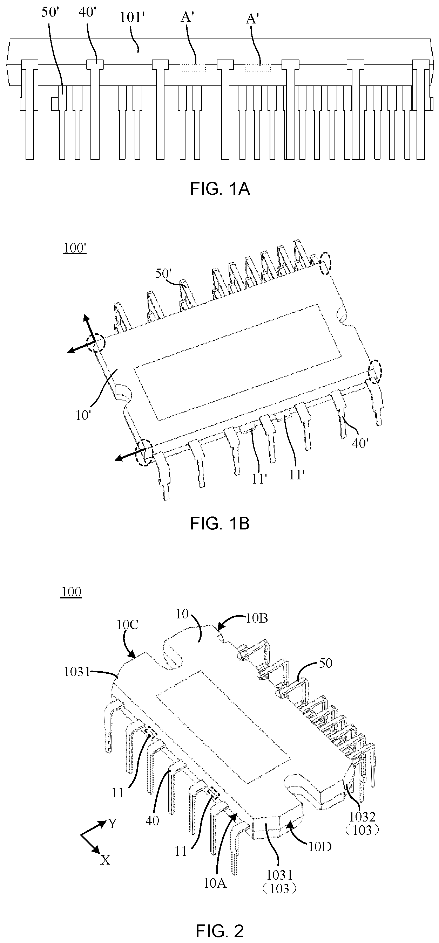

In the related art, a power module (PM) is usually packaged by transfer molding. As shown in FIG. 1A, a main structure of the power module, for example, including a power chip, a control chip, a heat dissipation substrate, and a pin frame (including a power pin 40' and a control pin 50'), is placed in a cavity of a mold 101', and then a liquid packaging resin is injected into the cavity through a resin injection opening A' on the mold. The mold 101' is disassembled after the packaging resin cures, so that the power module 100' in FIG. 1B may be obtained.

As shown in FIG. 1A, the mold has an upper housing and a lower housing, which are buckled together to form the internal cavity. The power pin and the control pin are led out from the buckled position between the upper housing and the lower housing. The resin injection opening A' is usually disposed on a side of the mold 101' from which the power pin 40' is led out, and located near the buckled position between the upper housing and the lower housing. Therefore, in the process of injecting the resin, the liquid packaging resin may flow from the position of the resin injection opening to two sides and forward. For example, the liquid packaging resin flows from the side from which the power pin 40' is led out to an opposite side from which the control pin 50' is led out, so that the resin gradually fills the cavity.

However, the liquid packaging resin may be blocked by a side wall of the cavity at a corner (corresponding to a corner of the formed packaging body 10' and as shown by the dashed circle in FIG. 1B) of the cavity when flowing to the corner of the cavity, which is not conducive to the continuous flow of the resin and causes the resin to stagnate and accumulate at this place. The liquid packaging resin is easily mixed with air at the stagnation and accumulation position, which causes a defect of gaps existing in the resin. This may cause the formed packaging body 10' to have a gap at this place. For the formed power module 100', there is a problem that the insulation withstand voltage and the insulation reliability are reduced at the position where the gap exists, which reduces the electrical safety of the power module.

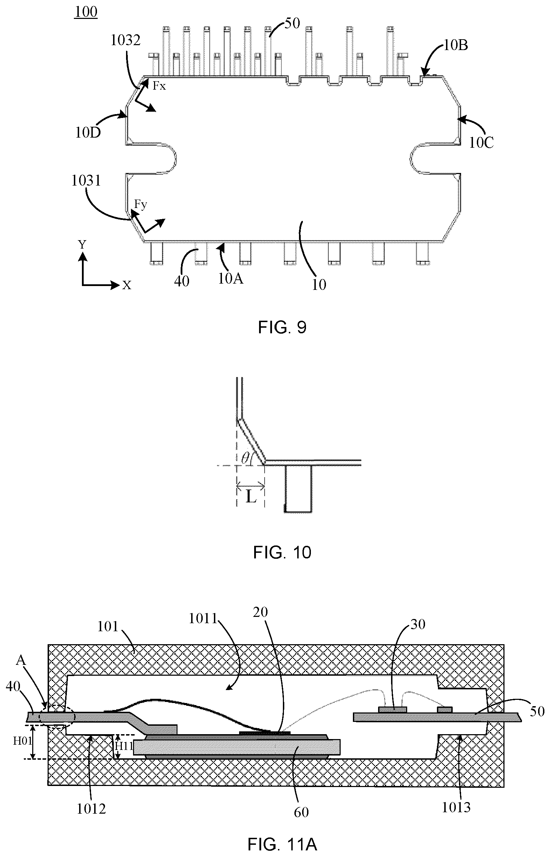

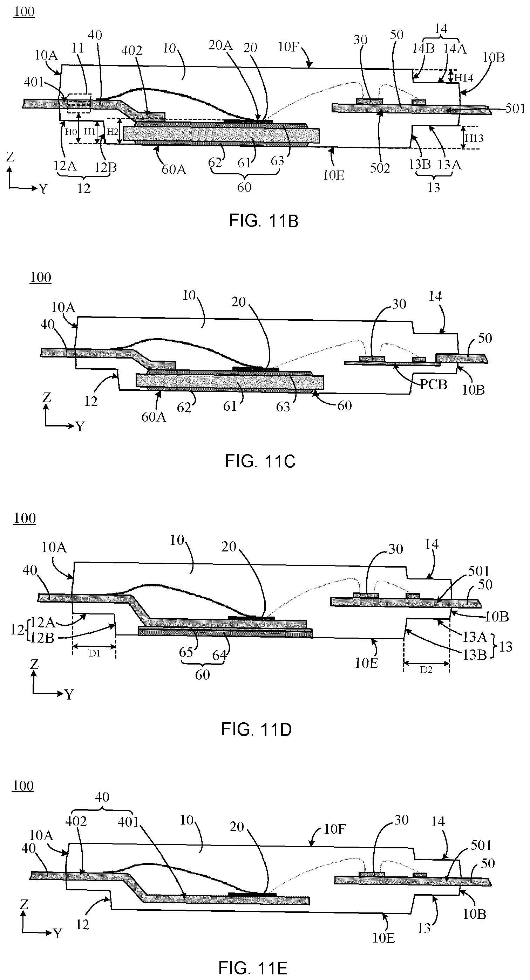

On this basis, a power module is provided in embodiments of the present disclosure. As shown in FIGS. 11B to 11E, a main structure of the power module 100 includes a power chip 20, a control chip 30, a power pin 40 electrically connected to the power chip 20, and a control pin 50 electrically connected to the control chip 30. The power pin 40 is used to connect the power chip 20 with an external driving component, and the control pin 50 is used to connect the control chip 30 with an external controller. The power chip 20 is also electrically connected to the control chip 30, and the control chip 30 is used to drive the power chip 20.

As shown in FIGS. 2 to 9 and 11B to 11E, the power module 100 further includes a packaging body 10 for packaging the main structure. The packaging body 10 has a first side 10A and a second side 10B that are disposed opposite to each other and both extend in a length direction X of the packaging body. A portion (hereinafter referred to as a first portion) of the power pin 40 is led out from the first side 10A of the packaging body 10, and another portion (hereinafter referred to as a second portion) of the power pin 40 is located in the packaging body 10 and electrically connected to the power chip 20. A portion (hereinafter referred to as a first portion) of the control pin 50 is led out from the second side 10B of the packaging body 10, and another portion (hereinafter referred to as a second portion) of the control pin 50 is located in the packaging body 10 and electrically connected to the control chip 30.

As shown in FIGS. 2 to 9, there are a plurality of power pins 40 and a plurality of control pins 50, and the length direction X of the packaging body is a direction in which the plurality of power pins 40 or the plurality of control pins 50 are arranged.

In the embodiments of the present disclosure, the main structure of the power module 100 is packaged by transfer molding, so as to form the packaging body 10. That is to say, the main structure of the power module 100 is placed in a cavity of a mold, and a resin injection opening is disposed on the mold (e.g., the resin injection opening is located on a side of the mold where the power pin 40 is led out). The liquid resin is injected into the cavity of the mold through the resin injection opening and fills between the main structure of the power module located in the cavity and walls of the cavity. The packaging body 10 in FIG. 2 may be formed after the resin cures. The packaging body 10 covers and protects the power chip 20 and the control chip 30, so that the structural reliability of the power module 100 may be improved.

As shown in FIGS. 2 to 9, the packaging body 10 includes a flow guide portion 103 located at least one corner of the packaging body 10, and the flow guide portion 103 is configured to achieve a function of guiding the resin to flow, so as to avoid a gap at the corner in the packaging body 10.

Here, the corner refers to a position where two adjacent sides with an included angle of the packaging body 10 are connected, for example, a position where the first side 10A of the packaging body is connected with a side (e.g., a third side or a fourth side described below) adjacent to the first side 10A and having an included angle with the first side 10A, or a position where the second side 10B of the packaging body is connected with a side (e.g., the third side or the fourth side described below) adjacent to the second side 10B and having an included angle with the second side 10B.

It may be understood that a shape of the walls of the cavity surrounded by the mold may match an outer shape of the packaging body 10 of the power module 100 in the embodiments of the present disclosure. In other words, the cavity of the mold may have a cavity wall structure corresponding to the outer shape structure of the packaging body 10.

For example, a portion of the formed packaging body 10 corresponding to the resin injection opening of the mold is referred to as a resin injection portion 11 (as shown in FIG. 2) of the packaging body 10. Roughness of the resin injection portion 11 is greater than that of other portions of the packaging body 10.

It may be seen from the above that the walls of the cavity of the mold have a cavity wall flow guide structure at a corner of the walls, and the cavity wall flow guide structure corresponds to the flow guide portion 103 included in the packaging body 10. When the resin flows to the cavity wall flow guide structure, the cavity wall flow guide structure located at the corner of the cavity may provide component force to guide the resin to an opposite side, so as to improve the fluidity of the resin at this place and guide the resin to continue to flow, and prevent the resin from stagnating and accumulating at the corner. In this way, the resin is difficult to be mixed with air at this place to cause the defect of gaps existing in the resin, so that the gaps at the corners in the formed packaging body 10 may be avoided, and the insulation and electrical safety of the power module 100 may be ensured.

Moreover, in the power module 100 provided in the embodiments of the present disclosure, it is possible to ensure the insulation and electrical safety of the power module 100 by providing the flow guide portion 103 at the corner of the packaging body 10, so that there is no need to add additional manufacturing device and the cost may be low.

In the embodiments of the present disclosure, there may be one or more flow guide portions 103. For example, the flow guide portion 103 may be disposed at a corner of a side of the packaging body 10 where the power pin 40 is led out. In this way, when the resin is injected, the cavity wall flow guide structure corresponding to the corner in the cavity may provide component force on the resin in a direction toward an opposite side, so as to guide the resin to flow to the opposite side, so that the stagnation and accumulation of the resin at the corner may be reduced. Similarly, the flow guide portion 103 may also be disposed at a corner of a side of the packaging body 10 where the control pin 50 is led out, so that the resin flowing to the corner in the cavity may flow to the middle of the side, thereby reducing the stagnation and accumulation of the resin at the corner.

It may be understood that the corresponding cavity wall flow guide structures may also be disposed at other corners in the cavity that may affect the flow of the resin, so as to form the corresponding flow guide portions 103 in the packaging body 10, so that the fluidity of the resin at this place may be improved, the resin may be prevented from stagnating and accumulating, the defect of gaps existing in the resin may be reduced, and the electrical safety of the power module may be ensured.

In some embodiments, the packaging body 10 includes a flow guide portion (hereinafter referred to as a first flow guide portion represented by 1031 in FIGS. 2 to 4 and 6 to 9) located at a corner of an end portion of the first side 10A of the packaging body 10 in the length direction X of the packaging body.

Here, the corner refers to a position where the first side 10A of the packaging body 10 is connected with a side (e.g., the third side 10C or the fourth side 10D described below) adjacent to the first side 10A.

For example, there may be one first flow guide portion 1031. The first flow guide portion 1031 may be disposed at a corner of an end portion of the first side 10A of the packaging body 10 in the length direction X of the packaging body, that is, at a corner where the first side 10A and the fourth side 10D are connected. Alternatively, the first flow guide portion 1031 may be disposed at a corner of another end portion of the first side 10A of the packaging body 10 in the length direction X of the packaging body, that is, at a corner where the first side 10A and the third side 10C (i.e., another side adjacent to the first side 10A in addition to the fourth side 10D) are connected.

For another example, as shown in FIGS. 2 to 4 and 6 to 9, there may be two first flow guide portions 1031, which are disposed at corners of two end portions of the first side 10A of the packaging body 10 in the length direction X of the packaging body, respectively, that is, disposed at a corner where the first side 10A and the fourth side 10D are connected and a corner where the first side 10A and the third side 10C are connected, respectively.

In this way, when the resin is injected, the cavity wall flow guide structure in the cavity corresponding to the first flow guide portion 1031 may provide component force to guide the resin to the opposite side, so as to improve the fluidity of the resin at this position and guide the resin to flow forward. As a result, it is possible to reduce the stagnation and accumulation of the resin at the position in the cavity corresponding to the corner, and reduce the gaps existing in the resin, and ensure the electrical safety of the power module.

In some examples, as shown in FIGS. 2 to 4 and 6 to 9, the first flow guide portion 1031 may be a chamfer. Here, the chamfer may be understood as a surface connecting the first side 10A and the third side 10C (or the fourth side 10D) and formed by cutting off sharp edges and having a certain angle with the first side 10A and the third side 10C (or the fourth side 10D).

For example, the resin injection opening is located on a side (i.e., a side corresponding to the first side 10A of the packaging body 10) of the mold where the power pin is led out, and the resin is injected into the cavity through the resin injection opening. When the resin flows to a position in the cavity corresponding to the first flow guide portion 1031, as shown in FIG. 9, the cavity wall flow guide structure in the cavity corresponding to the chamfer may provide component force Fy inclined to the opposite side (e.g., the second side 10B) for the resin at this position. As a result, the resin in the cavity flowing to the corner may flow forward, so that the resin may be prevented from stagnating and accumulating at the corner, and the gaps existing in the resin may be reduced.

It may be seen from the above that an angle of the chamfer may affect the guiding effect of the flow guide portion. For example, as shown in FIG. 10, an angle θ of the chamfer may be greater than or equal to 50°, and less than or equal to 70° (i.e., 50° ≤ θ ≤ 70°). In this way, not only a high guiding capacity of the chamfer may be ensured, but also raw materials may be saved. For example, the angle θ of the chamfer may be 50°, 60° or 70°, and the embodiments of the present disclosure are not limited thereto.

For example, as shown in FIG. 10, a side length L of the chamfer may be greater than 1.2 mm, so as to further improve the guiding capacity of the chamfer. For example, the side length L of the chamfer may be 1.2 mm, 1.4 mm or 1.6 mm, and the embodiments of the present disclosure are not limited thereto. As shown in FIG. 10, the side length L of the chamfer may be 1.4 mm.

The first flow guide portion 1031 is disposed at the corner between the first side 10A and the third side 10C (or the fourth side 10D), and the power module is usually installed according to the middle position in the width direction of the power module when the power module is used. Therefore, it may be understood that the side length L of the chamfer may not exceed 0.5 times the dimension of the third side 10C (or the fourth side 10D) in the width direction Y of the packaging body 10.

It will be noted that, in the embodiments of the present disclosure, a direction from the first side 10A to the second side 10B of the packaging body is referred to as the width direction Y of the packaging body, and a width direction of the power module is the same as the width direction Y of the packaging body.

Similarly, in some other examples, the first flow guide portion 1031 may also be a convex portion, such as an arc surface whose arc protrudes toward the outside of the packaging body 10, which may also achieve the effect of guiding the resin at the position in the cavity corresponding to the corner where the first flow guide portion 1031 of the packaging body 10 is located to flow forward. As a result, it is possible to prevent the resin from stagnating and accumulating at the corner, and reduce the gaps existing in the resin, and improve the electrical safety of the power module.

Of course, a shape of the first flow guide portion 1031 is not limited thereto, and the embodiments of the present disclosure are not limited thereto.

In some embodiments, as shown in FIGS. 2 to 4 and 6 to 9, the packaging body 10 further includes a flow guide portion (hereinafter referred to as a second flow guide portion 1032) at a corner of an end portion of the second side 10B in the length direction X of the packaging body.

Here, the corner refers to a position where the second side 10B of the packaging body 10 is connected with a side (hereinafter referred to as the third side 10C or the fourth side 10D) adjacent to the second side 10B.

For example, there may be one or two second flow guide portions 1032. For example, the second flow guide portion 1032 may be disposed at a corner of at least one end portion of the second side 10B of the packaging body 10 in the length direction X of the packaging body. That is to say, the second flow guide portion 1032 may be disposed at a corner where the second side 10B and the fourth side 10D are connected, and/or, at a corner where the second side 10B and the third side 10C are connected.

In this way, when the injected resin flows to a corner in the cavity corresponding to the second flow guide portion 1032, the cavity wall flow guide structure in the cavity corresponding to the second flow guide portion 1032 may provide component force (i.e., the component force Fx in FIG. 9) inclined to the middle for the resin flowing to this position, so as to guide the resin flowing to this position to flow to the middle of the cavity. As a result, it is possible to reduce the stagnation and accumulation of the resin at this corner, reduce the gaps existing in the resin, and ensure the electrical safety of the power module.

In some examples, the second flow guide portion 1032 may be a chamfer, a convex portion, or a concave portion.

For example, as shown in FIGS. 2, 3, 6 and 9, the second flow guide portion 1032 is a chamfer. For an angle and side length of the chamfer, reference may be made to the description of the first flow guide portion 1031, and details will not be repeated herein.

For another example, the second flow guide portion 1032 may also be a convex portion, such as an arc surface (not shown in the drawings) whose arc protrudes toward the outside of the packaging body.

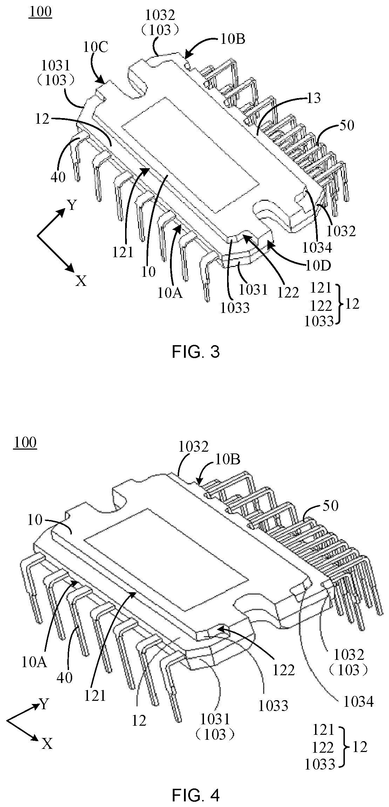

For another example, as shown in FIGS. 4, 7 and 8, the second flow guide portion 1032 is a concave portion. Similarly, the cavity wall flow guide structure in the cavity corresponding to the concave portion may squeeze the resin flowing to the corner, so that the resin may flow to the middle portion of the cavity. In this way, the raw materials may be saved while the resin is prevented from stagnating and accumulating at the corner to reduce the gaps existing in the resin.

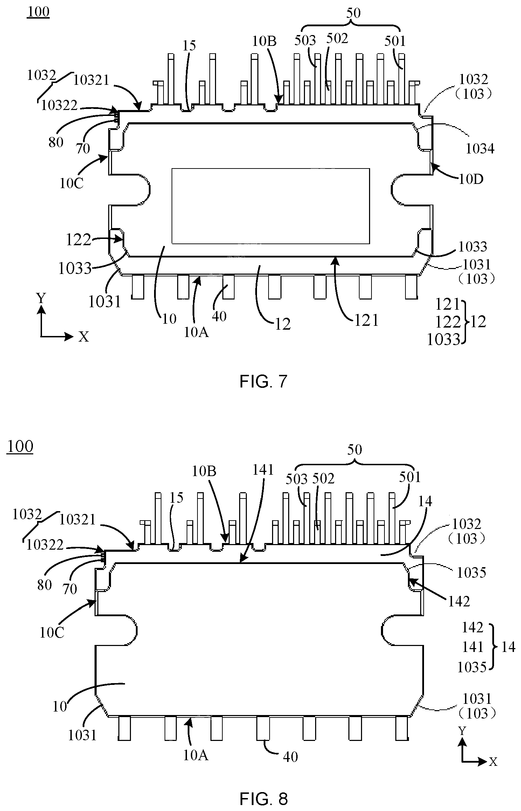

In some embodiments, in a case where the second flow guide portion 1032 is a concave portion, the second flow guide portion 1032 may be one concave portion, such as a second flow guide portion 1032 located at the corner between the second side 10B and the fourth side 10D in FIGS. 7 and 8; alternatively, the second flow guide portion 1032 may also be two continuous concave portions, such as a first concave portion 10321 and a second concave portion 10322, that is, the second flow guide portion 1032 located at a corner between the second side 10B and the third side 10C in FIGS. 7 and 8.

In some embodiments, as shown in FIGS. 3 to 7 and 11B to 11E, the packaging body 10 further includes a recessed first step portion 12. As shown in FIGS. 11B to 11E, the first step portion 12 is located on a side of a first portion 401 of the power pin 40 extending out of the packaging body 10, and the side is proximate to a bottom surface 10E of the packaging body.

Here, the recessed first step portion 12 means that the first step portion 12 is recessed toward the inside of the packaging body 10. That is to say, as shown in FIGS. 11B to 11E, the first step portion 12 has a step surface 12A and a side 12B. In the width direction Y of the packaging body 10, the side 12B of the first step portion 12 is closer to a center of the packaging body 10 than the first side 10A of the packaging body 10; and in the thickness direction Z of the packaging body 10, the step surface 12A of the first step portion 12 is closer to the center of the packaging body 10 than the bottom surface 10E of the packaging body.

Here, the center of the packaging body 10 may be understood as a physical center of gravity of the packaging body.

In the power module 100 provided in some embodiments of the present disclosure, as shown in FIGS. 11B to 11D, the main structure of the power module 100 further includes a heat dissipation substrate 60. The power chip 20 is disposed on the heat dissipation substrate 60, and the heat dissipation substrate 60 is used to dissipate heat from the power chip 20, so as to ensure normal operation of the power chip 20. A bottom surface of the heat dissipation substrate may be flush with the bottom surface 10E of the packaging body and exposed outside the packaging body 10, so as to improve the heat dissipation effect. In this case, the bottom surface 10E of the packaging body 10 serves as a heat dissipation surface of the power module 100.

It will be noted that, as shown in FIGS. 11B to 11D, a surface of the packaging body 10 on which the heat dissipation substrate 60 is disposed is referred to as the bottom surface 10E of the packaging body 10, a surface of the packaging body 10 opposite to the bottom surface 10E of the packaging body 10 is referred to as a top surface 10F of the packaging body, and a direction from the bottom surface 10E of the packaging body to the top surface 10F is referred to as the thickness direction Z of the packaging body.

For example, as shown in FIG. 11B, in the thickness direction Z of the packaging body, a distance H1 from the step surface 12A of the first step portion 12 to the bottom surface 10E of the packaging body is less than a distance H0 from the resin injection portion 11 to the bottom surface 10E of the packaging body.

It may be understood that in some embodiments of the present disclosure, the packaging body includes the first step portion 12. As shown in FIG. 11A, the cavity 1011 of the mold 101 for forming the packaging body 10 in FIG. 11B has a first cavity wall step 1012 corresponding to the first step portion 12, and the first cavity wall step 1012 is located on a side of the resin injection opening A proximate to a bottom portion of the mold. That is to say, a distance H11 from a step surface of the first cavity wall step 1012 to a bottom surface of the cavity is less than a distance H01 from the resin injection opening A to the bottom surface of the cavity.

In this way, when the resin is injected into the cavity of the mold through the resin injection opening, the resin may first fall onto the first cavity wall step 1012. The first cavity wall step 1012 has a certain buffering effect on the resin, so as to reduce the height at which the resin rushes toward the heat dissipation substrate 60, and reduce impact force of the resin on the heat dissipation substrate 60 in the inclined downward direction. As a result, the resin may flow to the heat dissipation substrate 60 as smoothly as possible, so that the problem of displacement defects in the heat dissipation substrate 60 may be alleviated, and the electrical safety and stability of the power module may be improved.

Moreover, the space (i.e., the space between the heat dissipation substrate 60 and the first cavity wall step 1012) between the heat dissipation substrate 60 and the side of the cavity corresponding to the power pin 40 is reduced by providing the first cavity wall step 1012, so that the amount of the resin accumulated in the space may be reduced when the resin is injected, and the risk of burrs caused by the resin overflowing from the bottom surface of the heat dissipation substrate 60 may be reduced.

In some examples, as shown in FIG. 11B, the distance H1 from the step surface 12A of the first step portion 12 to the bottom surface 10E of the packaging body is less than a distance H2 from a top surface 20A (i.e., a surface away from the bottom surface 10E of the packaging body) of the power chip 20 to the bottom surface 10E of the packaging body 10. Correspondingly, as shown in FIG. 11A, the distance H11 from the step surface of the cavity wall step 1012 disposed in the cavity of the mold to the bottom surface of the cavity is less than a distance from the top surface 20A of the power chip 20 to the bottom surface of the cavity.

In this way, when the resin is injected into the cavity through the resin injection opening A, the resin flows to the heat dissipation substrate 60 and the power chip 20 through the cavity wall step 1012. At this time, the resin tends to flow gently toward the heat dissipation substrate 60 in a horizontal direction, which greatly reduces impact force of the resin on the heat dissipation substrate 60, so that the displacement defects caused by impact force of the resin on the heat dissipation substrate 60 may be further reduced.

Moreover, in a case where the distance H1 from the step surface 12A of the first step portion 12 to the bottom surface 10E of the packaging body 10 is small, the space between the heat dissipation substrate 60 and the side of the cavity corresponding to the power pin is also small, which may further reduce the amount of the resin accumulated in the space, thereby reducing the risk of burrs caused by the resin overflowing from the bottom surface of the heat dissipation substrate 60.

In some embodiments, as shown in FIGS. 3 to 7, the first step portion 12 includes a main body portion 121 extending in the length direction X of the packaging body 10 and at least one end portion 122 extending in the width direction Y of the packaging body 10. For example, there may be one end portion 122 located on a side of the main body portion 121 in the length direction X of the packaging body 10. For another example, there may be two end portions 122 located on two sides of the main body portion 121 in the length direction X of the packaging body 10, respectively.

In this case, the first step portion 12 further includes a third flow guide portion 1033 connecting the main body portion 121 and the end portion 122 of the first step portion 12.

It may be understood that the third flow guide portion 1033 is located at a corner of the first step portion 12, so as to prevent the resin from stagnating and accumulating when the resin flows to the position in the cavity corresponding to the corner.

For example, in a case where the first step portion 12 includes only one end portion 122, the first step portion 12 includes only one third flow guide portion 1033. For another example, in a case where the first step portion 12 includes two end portions 122, the first step portion 12 may include two third flow guide portions 1033, and one third flow guide portion 1033 connects one end portion 122 and the main body portion 121.

It may be understood that in a case where the first step portion 12 includes the third flow guide portion 1033, correspondingly, the first cavity wall step in the cavity of the mold for forming the packaging body 10 corresponding to the first step portion also has a cavity wall flow guide structure corresponding to the third flow guide portion 1033.

In this way, when the resin is injected into the cavity and the resin flows to the corner in the cavity corresponding to the third flow guide portion 1033, the cavity wall flow guide structure in the cavity corresponding to the third flow guide portion 1033 may provide component force to guide the resin to the opposite side, so as to improve the fluidity of the resin at this position and guide the resin to flow forward, so that the resin may be prevented from stagnating at this position and the gaps existing in the resin may be further reduced.

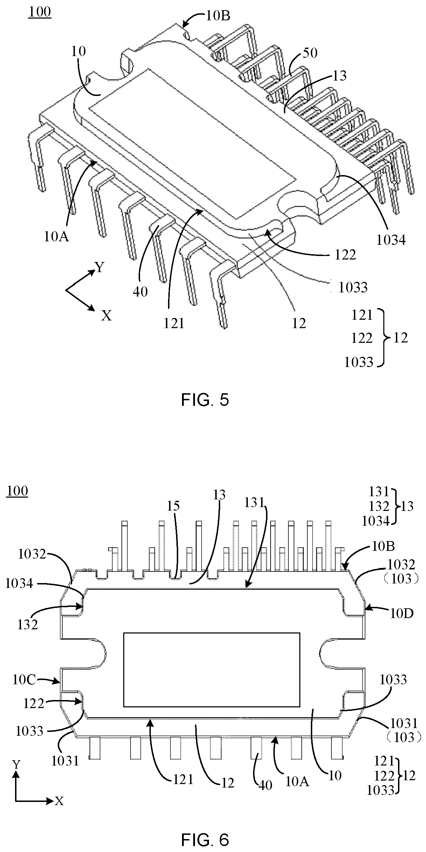

In some examples, as shown in FIGS. 3, 4, 6 and 7, the third flow guide portion 1033 may be a chamfer. In some other examples, the third flow guide portion 1033 may be a convex portion. For example, as shown in FIG. 5, the third flow guide portion 1033 is an arc surface protruding toward the outside of the packaging body 10.

Here, for the specific arrangement of the third flow guide portion 1033 and the effects generated by the third flow guide portion 1033, reference may be made to the description of the first flow guide portion 1031, and details will not be repeated herein.

In some embodiments, as shown in FIGS. 3 to 7 and 11B to 11E, the packaging body 10 further includes a recessed second step portion 13. As shown in FIGS. 11B to 11E, the second step portion 13 is located on a side of a first portion 501 of the control pin 50 extending out of the packaging body 10, and the side is proximate to the bottom surface 10E of the packaging body.

Here, similar to the recessed first step portion 12, the recessed second step portion 13 means that the second step portion 13 is recessed toward the inside of the packaging body 10. That is to say, the second step portion 13 has a step surface 13A and a side 13B. In the width direction Y of the packaging body 10, the side 13B of the second step portion 13 is closer to the center of the packaging body 10 than the second side 10B of the packaging body 10; and in the thickness direction Z of the packaging body 10, the step surface 13A of the second step portion 13 is closer to the center of the packaging body 10 than the bottom surface 10E of the packaging body.

In some embodiments of the present disclosure, the second step portion 13 is disposed on the side of the first portion 501 of the control pin 50 extending out of the packaging body 10 proximate to the bottom surface 10E of the packaging body 10. Correspondingly, as shown in FIG. 11A, the cavity 1011 of the mold 101 has a second cavity wall step 1013 corresponding to the second step portion 13 of the packaging body 10. In this way, the arrangement of the second cavity wall step 1013 may reduce the space (i.e., the space between the heat dissipation substrate 60 and the second cavity wall step 1013) between the heat dissipation substrate 60 and the side of the cavity corresponding to the control pin 50, so that the amount of the resin accumulated in the space may be reduced, and the risk of burrs caused by the resin overflowing from the bottom surface of the heat dissipation substrate 60 may be further reduced.

In some examples, in the thickness direction Z of the packaging body 10, a distance H13 from the step surface 13A of the second step portion 13 to the bottom surface 10E of the packaging body is substantially equal to the distance H1 from the step surface 12A of the first step portion 12 to the bottom surface 10E of the packaging body 10. Moreover, as shown in FIG. 11C, in the width direction Y of the packaging body 10, a distance D2 from the side 13B of the second step portion 13 to the second side 10B of the packaging body 10 is also substantially equal to a distance D1 from the side 12B of the first step portion 12 to the first side 10A of the packaging body 10. That is to say, the second step portion 13 and the first step portion 12 are substantially disposed symmetrically in the width direction Y of the packaging body 10.

Such arrangement not only simplifies the manufacturing process, but also makes the resin easily fill the space between the heat dissipation substrate 60 and the side of the cavity corresponding to the control pin 50, so as to avoid the defect of gaps existing in the resin in this space.

In some embodiments, as shown in FIGS. 8 and 11B to 11E, the packaging body 10 further includes a recessed third step portion 14. As shown in FIGS. 11B to 11E, the third step portion 14 is located on a side of the first portion 501 of the control pin 50 extending out of the packaging body 10, and the side is away from the bottom surface 10E of the packaging body.

Here, similar to the recessed first step portion 12, the recessed third step portion 14 means that the third step portion 14 is recessed toward the inside of the packaging body 10. That is to say, the third step portion 14 has a step surface 14A and a side 14B. In the width direction Y of the packaging body, the side 14B of the third step portion 14 is closer to the center of the packaging body 10 than the second side 10B of the packaging body; and in the thickness direction Z of the packaging body, the step surface 14A of the third step portion 14 is closer to the center of the packaging body 10 than the top surface 10F of the packaging body.

It will be noted that a surface of the packaging body 10 which is perpendicular to the thickness direction Z of the packaging body 10 and on which the heat dissipation substrate 60 is not disposed is referred to as the top surface 10F of the packaging body 10.

The side in the cavity where the control pin 50 is disposed is far away from the resin injection opening. Therefore, by providing the second step portion 13 and the third step portion 14 located on two sides of the first portion 501 of the control pin 50 extending toward the outside of the packaging body 10 in the packaging body, respectively, the mold flow speed of the resin on the side in the cavity where the control pin 50 is disposed may be adjusted when the resin is injected. As a result, the mold flow speeds in the entire cavity may be even and the gaps may be avoided, and the resin injection time may also be sped up.

In some examples, as shown in FIG. 11B, a distance H14 from the step surface 14A of the third step portion 14 to the top surface 10F of the packaging body is less than the distance H13 from the step surface 13A of the second step portion 13 to the bottom surface 10E of the packaging body and/or the distance H1 from the step surface 12A of the first step portion 12 to the bottom surface 10E of the packaging body.

In this way, the mold flow speed of the resin on the side in the cavity where the control pin is disposed may be further adjusted on the premise of ensuring that the resin may completely submerge the control chip 30, so as to make the mold flow speeds in the entire cavity even and avoid the gaps.

In some embodiments, as shown in FIGS. 3 to 8, the flow guide portion is also disposed at a corner of the second step portion 13 and/or the third step portion 14 included in the packaging body 10, and the flow guide portion is configured to achieve a function of guiding the resin to flow, so as to prevent the resin from stagnating and accumulating when the resin flows to the position in the cavity corresponding to the corner. For example, a fourth flow guide portion 1034 is disposed at a corner of the second step portion 13. For another example, a fifth flow guide portion 1035 is disposed at a corner of the third step portion 14.

For example, as shown in FIG. 6, the second step portion 13 includes a main body portion 131 extending in the length direction X of the packaging body 10 and at least one end portion 132 extending in the width direction Y of the packaging body 10, and the fourth flow guide portion 1034 is connected between the main body portion 131 and the end portion 132.

For another example, as shown in FIG. 8, the third step portion 14 includes a main body portion 141 extending in the length direction X of the packaging body 10 and at least one end portion 142 extending in the width direction Y of the packaging body 10, and the fifth flow guide portion 1035 is connected between the main body portion 141 and the end portion 142.

In some embodiments, the fourth flow guide portion 1034 and/or the fifth flow guide portion 1035 each may be a chamfer or a convex portion. For the specific shapes of the fourth flow guide portion 1034 and the fifth flow guide portion 1035 and the effects generated by the fourth flow guide portion 1034 and the fifth flow guide portion 1035, reference may be made to the description of the second flow guide portion 1032, and details will not be repeated herein.

In the power module provided in some embodiments of the present disclosure, the main structure of the power module may adopt various structural layouts, which are not specifically limited herein.

For example, the main structure of the power module 100 adopts a layout of a direct bond copper (DBC) ceramic substrate. As shown in FIG. 11B, the heat dissipation substrate 60 included in the main structure of the power module 100 is a double-sided copper-clad ceramic substrate (also referred to as a DBC ceramic substrate) in a one-piece structure, and includes a ceramic substrate 61, and a copper layer 62 and another copper layer 63 located on two sides of the ceramic substrate 61, respectively. The power chip 20 may be disposed on the copper layer 62 of the double-sided copper-clad ceramic substrate. For example, the power pin 40 is directly soldered onto the copper layer 62 of the double-sided copper-clad ceramic substrate. That is to say, the copper layer 62 serves as a power chip pad for mounting the power chip 20. The another copper layer 63 of the double-sided copper-clad ceramic substrate is flush with the bottom surface 10E of the packaging body 10 and exposed outside the packaging body 10. That is to say, a surface of the another copper layer 63 of the double-sided copper-clad ceramic substrate away from the ceramic substrate 61 is flush with the bottom surface 10E of the packaging body 10 and exposed outside the packaging body 10. In this embodiment, the DBC ceramic substrate may achieve both conductive connection to the power chip 20 and heat conduction to the power chip 20. A control chip pad is disposed on (i.e., a side away from the bottom surface 10E of the packaging body) a second portion 502 of the control pin 50 located in the packaging body 10, and the control chip is mounted on the control chip pad.

For another example, the main structure of the power module 100 adopts a layout in which a DBC structure and a printed circuit board PCB are simultaneously disposed. As shown in FIG. 11C, the heat dissipation substrate 60 included in the main structure of the power module 100 is a DBC ceramic substrate, and its structure is the same as the DBC ceramic substrate in FIG. 11B, and details will not be repeated herein. In this case, the power module 100 further includes a PCB packaged in the packaging body 10, and the PCB may serve as a control chip pad for mounting the control chip 30. That is to say, the control chip 30 is mounted on the printed circuit board PCB; the control pin 50 may be soldered on the printed circuit board PCB.

For another example, the main structure of the power module 100 adopts a layout in which a heat dissipation sheet is disposed. As shown in FIG. 11D, the heat dissipation substrate 60 included in the main structure of the power module 100 includes a heat dissipation copper sheet 64 and an insulating layer 65 located on heat dissipation copper sheet 64. A second portion 42 of the power pin located in the packaging body may extend onto the heat dissipation substrate 60. A power chip pad (not shown in the drawings) is disposed on (i.e., a side away from the heat dissipation substrate 60) the second portion 42 of the power pin located in the packaging body, and the power chip 20 may be mounted on the power chip pad. A control chip pad is disposed on (i.e., a side away from the bottom surface 10E of the packaging body) the second portion 502 of the control pin 50 located in the packaging body 10, and the control chip 30 is mounted on the control chip pad.

For another example, the main structure of the power module 100 adopts a full-frame layout. As shown in FIG. 11E, the second portion 42 of the power pin located in the packaging body may serve as a first copper frame, and the power chip 20 may be mounted on the first copper frame. That is to say, the second portion 42 of the power pin located in the packaging body may serve as a power chip pad for mounting the power chip 20. The second portion 502 of the control pin 50 located in the packaging body 10 may serve as a second copper frame, and the control chip 30 may be mounted on the second copper frame. That is to say, the second portion 502 of the control pin 50 located in the packaging body 10 may serve as a control chip pad for mounting the control chip 30.

In some embodiments of the present disclosure, the mold for forming the packaging body 10 by transfer molding may have a plurality of resin injection openings, and the plurality of resin injection openings may be arranged at intervals on a side of the mold from which the plurality of power pins 40 are led out. For example, in a length direction (i.e., the length direction X of the packaging body) of the mold, each resin injection opening may be located between two power pins 40. Correspondingly, in some embodiments, the packaging body 10 has a plurality of resin injection portions 11, and the plurality of resin injection portions 11 may be arranged at intervals on the first side 10A of the packaging body.

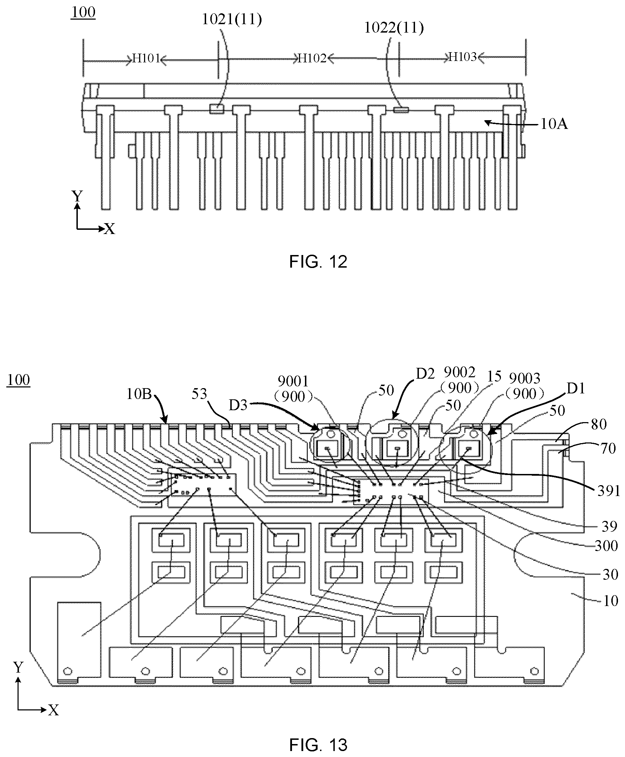

For example, as shown in FIG. 12, the packaging body 10 has two resin injection portions 11, such as a first resin injection portion 1021 and a second resin injection portion 1022. In the length direction X of the packaging body 10, the first resin injection portion 1021 and the second resin injection portion 1022 are evenly located on the first side 10A of the packaging body 10. That is to say, in the length direction X of the packaging body 10, a distance H101 between the first resin injection portion 1021 and its closest corner, a distance H102 between the first resin injection portion 1021 and the second resin injection portion 1022, and a distance H103 between the second resin injection portion 1022 and its closest corner are approximately equal to each other.

In this way, when the resin is injected, the resin may flow evenly to the left side and right side and middle portion of the cavity, which is conducive to the uniformity of resin filling in the cavity and may also achieve the effect of reducing the gaps existing in the resin.

In the power module 100 provided in the embodiments of the present disclosure, the control chip 30 is used to drive and control the power chip 20. The control chip 30 is generally used to receive control signals from the outside or instructions from a microprocessor and convert these instructions into signals suitable for driving the power chip.

In some embodiments, as shown in FIG. 13, the main structure of the power module 100 further includes a control chip pad 300 for mounting the control chip 30. The control chip pad 300 may provide a stable and reliable installation position for the control chip 30, thereby ensuring that the control chip 30 operates stably in the power module 100.

The main structure of the power module 100 further includes a bootstrap chip 90 and a bootstrap chip pad 900 for mounting the bootstrap chip 90. The bootstrap chip 90 is connected to an external power source and may be used to, for example, increase a power supply voltage supplied by the external power source. For example, the bootstrap chip 90 is electrically connected to a pin 53 (referred to as a third functional pin in the following embodiments for the purpose of distinguishing different pins) through a trace 391, and the pin may serve as a high voltage pin.

The bootstrap chip pad 900 and the control chip pad 300 are arranged at an interval. That is to say, there is a gap between the bootstrap chip pad 900 and the control chip pad 300, so that the bootstrap chip pad 900 and the control chip pad 300 are not electrically connected with each other, thereby ensuring that each of the bootstrap chip 90 and the control chip 30 has an independent and reliable installation position, and ensuring the normal operation of the power module 100.

For example, the bootstrap chip pad 900 and the control chip pad 300 may be arranged at an interval in the width direction of the power module 100.

It will be noted that the width direction of the power module 100 is the same as the width direction Y of the packaging body, and the length direction of the power module 100 is also the same as the length direction X of the packaging body.

The bootstrap chip pad 900 includes a partition portion 901 separating the bootstrap chip pad 900 into two portions, that is, a chip soldering portion 902 and a trace connecting portion 903. The chip soldering portion 902 is used to carry the bootstrap chip 90, and the trace connecting portion 903 is used to electrically connect the bootstrap chip pad 900 with the control chip 30 through a trace 39, thereby achieving circuit connectivity of the power module 100.

The partition portion 901 is disposed on the bootstrap chip pad 900, so that the chip soldering portion 902 and the trace connecting portion 903 on the bootstrap chip pad 900 may also be separated from each other on the premise that the bootstrap chip pad 900 provides a stable and reliable installation position for the bootstrap chip 90 and a stable and reliable connection position for the trace 39.

When the bootstrap chip 90 is soldered onto the chip soldering portion 902, the solder used for soldering may flow out from the chip soldering portion 902 and spread around. In this case, the partition portion 31 may receive the solder flowing out. In this way, a problem of short circuit of the traces caused by the solder flowing to the trace connecting portion 903 and in contacted with the trace 39 may be avoided, so that the operating safety and stability of the power module 100 may be improved when the bootstrap chip 90 is soldered.

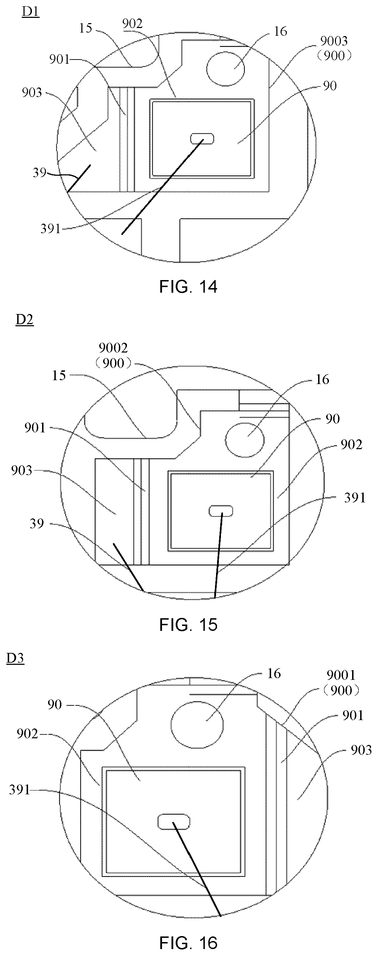

In some embodiments, as shown in FIGS. 14 to 16, the partition portion 901 is a groove in a shape of a strip.

The partition portion 901 mainly plays a role of separating the chip soldering portion 902 and the trace connecting portion 903 on the bootstrap chip pad 900. The partition portion 901 is configured as a groove in a shape of a strip, which may extend a length of the partition portion 901 on the bootstrap chip pad 900. In this way, it is possible to not only ensure that the partition portion 901 completely separate the chip soldering portion 902 and the trace connecting portion 903, so as to effectively prevent the solder from flowing to the trace connecting portion 903 when the bootstrap chip 90 is soldered, but also increase the amount of solder that may be received by the partition portion 901, so that the partition portion 901 may receive as much solder as possible. As a result, it is possible to effectively ensure that the trace 39 for connecting the bootstrap chip pad 90 and the control chip 30 may be normally connected onto the trace connecting portion 903 when the bootstrap chip 90 is soldered, so that the circuit stability of the power module 100 may be improved.

In some embodiments, in combination with FIGS. 13 to 16, the control chip pad 300 and the bootstrap chip pad 900 are arranged at an interval in the width direction of the power module 100, and the partition portion 901 extends in the width direction of the power module 100, so as to separate the bootstrap chip pad 900 into the chip soldering portion 902 and the trace connecting portion 903 in the length direction of the power module 100.

In these embodiments, the control chip pad 300 and the bootstrap chip pad 900 are arranged at an interval in the width direction of the power module 100. In this way, it is possible to not only optimize the structural arrangement of the control chip pad 300 and the bootstrap chip pad 900 in the power module 100, but also facilitate the wiring and connection of the trace 39 for connecting the control chip pad 300 and the control chip 30 in the power module 100.

In addition, the partition portion 901 extends in the width direction of the power module 100, which may shorten a processing length of the partition portion 901 on the bootstrap chip pad 900 while ensuring that the partition portion 901 may effectively receive the overflowing solder, so that processing time of the partition portion 901 may be shortened and the production efficiency of the power module 100 may be effectively improved.

Meanwhile, the partition portion 901 extends in the width direction of the power module 100, which may separate the bootstrap chip pad 900 into the chip soldering portion 902 and the trace connecting portion 903 in the length direction of the power module 100. In this way, it is conducive to arranging the positions of the chip soldering portion 902 and the trace connecting portion 903 on the bootstrap chip pad 900, so that the chip soldering portion 902 is conducive to the soldering operation of the bootstrap chip 90, and the trace connecting portion 903 is conducive to the connection operation of the trace 39, which may increase the installation convenience of the power module 100.

In some embodiments, as shown in FIG. 13, there are a plurality of bootstrap chip pads 900, and each bootstrap chip pad 900 is provided with a bootstrap chip 90. In this way, it is possible to not only make the number of bootstrap chips 90 in the power module 100 meet the operating requirements of the electronic device to which the power module 100 is applied, but also ensure that each bootstrap chip 90 has a stable and independent installation space in the power module 100, thereby ensuring the installation convenience and operating reliability of the bootstrap chips 90 in the power module 100.

As shown in FIG. 13, the plurality of bootstrap chip pads 900 are arranged at intervals in the length direction of the power module 100. Moreover, in the length direction of the power module 100, the trace connecting portion 903 included in a bootstrap chip pad 900 of the plurality of bootstrap chip pads 900 located at at least one end is closer to the control chip 30 than the chip soldering portion 902 included in the bootstrap chip pad 900.

In this way, it is possible to ensure that a width (i.e., a dimension in the width direction of the power module 100) of the bootstrap chip pad 900 cannot be increased when the plurality of bootstrap chips 90 are mounted on the power module 100 at the same time, so that the structural compactness of the power module 100 and the space utilization of the power module 100 may be improved.

Moreover, in a case where the bootstrap chip pad 900 and the control chip pad 300 are arranged at an interval in the width direction of the power module 100, the trace 39 may be conveniently connected with the control chip 30 and the trace connecting portion 903 of the bootstrap chip pad 900, so that the circuit connectivity of the power module 100 may be ensured and the power module 100 may operate normally.

In some examples, as shown in FIGS. 13 to 16, the plurality of bootstrap chip pads 900 include a first bootstrap chip pad 9001, a second bootstrap chip pad 9002, and a third bootstrap chip pad 9003 arranged at intervals in the length direction of the power module 100.

The second bootstrap chip pad 9002 is located between the first bootstrap chip pad 9001 and the third bootstrap chip pad 9003, the trace connecting portions 903 of the first bootstrap chip pad 9001 and the third bootstrap chip pad 9003 are both disposed proximate to the second bootstrap chip pad 9002. The trace connecting portion 903 of the second bootstrap chip pad 9002 is disposed proximate to the first bootstrap chip pad 9001 or the third bootstrap chip pad 9003.

For example, the first bootstrap chip pad 9001 is located at an end of the plurality of bootstrap chip pads 900 in the length direction of the power module 100, and the trace connecting portion 903 included in the first bootstrap chip pad 9001 is closer to the control chip 30 than the chip soldering portion 902 included in the first bootstrap chip pad 9001. Similarly, the third bootstrap chip pad 9003 is located at another end of the plurality of bootstrap chip pads 900 in the length direction of the power module 100, and the trace connecting portion 903 included in the third bootstrap chip pad 9003 is also closer to the control chip 30 than the chip soldering portion 902 included in the third bootstrap chip pad 9003.

Such arrangement may shorten a length of the trace 39 connecting each of the bootstrap chip pads 900 and the control chip 30, reduce the material consumed by the trace 39, and also improve the efficiency that the trace 39 connects the bootstrap chip pad 900 and the control chip 30.

The power module 100 provided in some embodiments of the present disclosure includes a plurality of control pins 50, and the plurality of control pins 50 may provide interfaces for the electrical connection between the power module 100 and the external device. The plurality of control pins 50 are all electrically connected to the control chip 30, so that the reliability of the electrical connection between the control chip 30 and the external device may be ensured.

In some embodiments, a control pin 50 is disposed between two adjacent bootstrap chip pads 900. In this way, the bootstrap chip 90 on each bootstrap chip pad 900 may be conveniently electrically connected to the external device, and the operating reliability of the control chip 30 and the bootstrap chip 90 may be ensured, thereby ensuring the operating reliability of the power module 100.

In some examples, as shown in FIG. 13, an area occupied by the chip soldering portion 902 is greater than an area occupied by the trace connecting portion 903. In this way, the area occupied by the chip soldering portion 902 on the bootstrap chip pad 900 may meet the soldering requirements of the bootstrap chip 90; moreover, a contacting area between the bootstrap chip 90 and the chip soldering portion 902 may be increased while the stable connection between the trace 39 and the bootstrap chip pad 900 is ensured, so that the connection reliability of the bootstrap chip 90 on the bootstrap chip pad 900 may be improved. In this way, the structural arrangement of the bootstrap chip pad 900 may be reasonable, which may be conducive to the production and assembly of the power module 100.

In some embodiments, as shown in FIGS. 13 to 16, a through hole 16 is disposed on the chip soldering portion 902. The through hole 16 is located on a side of the bootstrap chip 90 mounted on the chip soldering portion 902 away from the control chip 30.

When the main structure of the power module 100 is packaged by the transfer molding, the resin may be injected into the cavity of the mold through the through hole 16. In this way, the through hole 16 is filled with the packaging body 10 after the resin cures, so that the bonding between the main structure of the power module 100 and the packaging body 10 may be improved.

In addition, the through hole 16 is filled with the packaging body 10, the packaging body 10 may isolate external water or air, and the through hole 16 is disposed between a portion of the chip soldering portion 902 connecting the outside and a portion of the chip soldering portion 902 for mounting the bootstrap chip 90. Therefore, it is also possible to prevent external water or air from entering the inside of the chip through the chip soldering portion 902 of the bootstrap chip pad 900, which may further improve the structural reliability of the power module 100.

In some embodiments, as shown in FIGS. 6 to 8 and 13, the packaging body 10 further includes an isolation portion 15. The isolation portion 15 is located on the second side 10B of the packaging body 10, that is, on a side of the packaging body 10 from which the plurality of control pins 50 are led out. The isolation portion 15 is used to increase a creepage distance between the control pins 50, which may avoid the creepage phenomenon when a surface of the power module 100 is in contact with an external electrical conductor, thereby ensuring the safety and stability of the power module 100 during operation.

For example, the isolation portion 15 may be a concave portion. In this way, the creepage distance between the conductors may be increased while the raw material is saved and the structural compactness of the power module is improved.

For example, there may be a plurality of isolation portions 15. Each isolation portion 15 may be located between two adjacent control pins 50, so as to increase the creepage distance between the control pins 50.

In the power module 100 provided in some embodiments of the present disclosure, as shown in FIG. 13, the power module 100 further includes a bootstrap chip 90 and a bootstrap chip pad 900. The bootstrap chip pad 900 is connected to the external device through a pin, and a control pin 50 is disposed between two adjacent bootstrap chip pads. In this case, the isolation portion 15 may be located between the control pin 50 and the bootstrap chip pad 900. On the premise of ensuring the structural stability of the bootstrap chip pad 900 in the power module 100, the creepage distance between the bootstrap chips 40 may be increased, and the creepage phenomenon when the surface of the power module 100 is in contact with an external electrical conductor may be avoided, thereby ensuring the safety and stability of the power module 100 during operation.

In the power module 100 provided in the embodiments of the present disclosure, there are a plurality of control pins 50 led out from the second side 10B of the packaging body 10 extending in the length direction X of the packaging body 10. That is to say, the plurality of control pins 50 are arranged along the second side 10B.

In some embodiments, as shown in FIGS. 7, 8, 13, and 17 to 21, the power module 100 further includes a first supporting pin 70 led out from a third side 10C of the packaging body 10 and only used to support the power module 100. The third side 10C is adjacent to the second side 10B and extends in the width direction Y of the packaging body 10.

The plurality of control pins 50 include a first functional pin 51 and a second functional pin 52. In the length direction X of the packaging body 10, the second functional pin 52 is proximate to a middle portion of the second side 10B of the packaging body 10, and the first functional pin 51 is located on a side of the second functional pin 52 away from the first supporting pin 70.

That is to say, the first functional pin 51, the second functional pin 52 and the first supporting pin 70 are substantially arranged evenly in the length direction X of the packaging body 10 in sequence, and are led out from different sides of the packaging body 10, and are configured to support the power module 100 from different sides of the power module 100, so as to improve the stability of the power module 100.

In this way, the first functional pin 51, the second functional pin 52 and the first supporting pin 70 may support the entire power module 100 from two sides of the power module 100, so that the shaking problem caused by supporting the power module 100 from a single side of the power module 100 may be avoided, the stability of the power module 100 may be improved and the power module 100 may be prevented from being deformed.

Moreover, the first supporting pin 70 is led out from the third side 10C of the packaging body 10, which may avoid increasing the space of the power module 100 in the length direction X that is occupied by the first supporting pin 70 and avoid wasting materials. As a result, it is possible to make the arrangement of the pins used to support the power module 100 reasonable and compact, so that the volume of the power module 100 may be reduced and the miniaturization of the power module 100 may be improved.

In addition, the first functional pin 51 and the second functional pin 52 are led out from the second side 10B of the packaging body 10, and the first supporting pin 70 is led out from the third side 10C of the packaging body 10, which may also increase the insulation distance between these pins, thereby improving the safety performance of the power module 100.

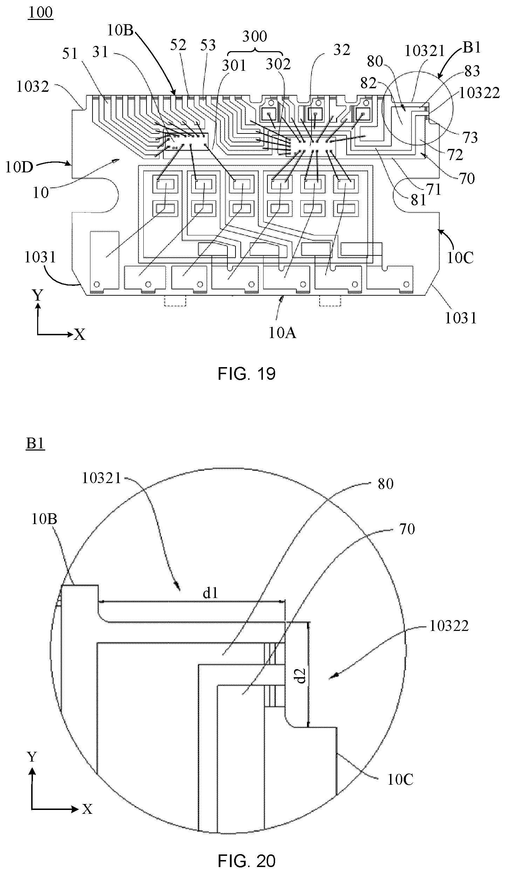

In some embodiments, as shown in FIGS. 13 and 19, the power module 100 further includes a control chip pad 300, and the control chip 30 is disposed on the control chip pad 300, so that the stability and reliability of the installation of the control chip 30 may be ensured and the performance of the control chip 30 may be improved.

The first functional pin 51, the second functional pin 52 and the first supporting pin 70 are connected to the control chip pad 300. For example, the first functional pin 51, the second functional pin 52 and the first supporting pin 70 are connected to the control chip pad 300 as a one-piece structure. Alternatively, in some embodiments, it may also be understood that different portions of the control chip pad 300 form the pad for mounting the control chip 30, and the first functional pin 51, the second functional pin 52 and the first supporting pin 70, respectively.

The first functional pin 51 and the second functional pin 52 are led out from the second side 10B of the packaging body 10 and both electrically connected to the peripheral circuit, which not only ensures the normal operation of the power module 100 but also supports the power module 100 and ensures the reliability of the installation of the power module 100. The first supporting pin 70 is led out from the third side 10C of the packaging body 10, so that the power module 100 may be supported by the first supporting pin 70 from a side different from the side from which the control pin 50 is led out, so as to ensure the reliability of the installation of the power module 100.

It may be seen that in the power module 100 provided in some embodiments of the present disclosure, the pads in the power module 100 for mounting the control chip 30 may be used to form pins for supporting the power module 100, there is no need to add additional pins for supporting the power module, so that the space occupied by the pins for supporting the power module may be reduced and the miniaturization of the power module 100 may be improved.

In some embodiments, as shown in FIG. 19, the power module 100 includes a plurality of control chips 30, such as a first control chip 31 and a second control chip 32. According to different uses of the power module 100, the first control chip 31 may serve as a low-voltage chip, and the second control chip may serve as a high-voltage chip, which may improve the operating performance of the power module 100.

In this case, the control pad 300 includes: a first control chip pad 301 and a second control chip pad 302 that may be formed into a one-piece structure. The first control chip pad 301 and the second control chip pad 302 are connected in sequence in the length direction X of the packaging body 10. The first control chip 301 is disposed on the first control chip pad 301, and the second control chip 32 is disposed on the second control chip pad 302, which may improve the structural compactness of the power module 100.

In some examples, the first functional pin 51 is electrically connected to the first control chip 31 and may be used to provide a ground voltage to the first control chip 31. The first functional pin 51 is disposed on a side of the first control chip pad 301 in the length direction of the power module. The first supporting pin 70 is disposed on a side of the second control chip pad 302 in the length direction of the power module away from the first control chip pad 301. The second functional pin 52 is disposed proximate to a middle position of the second control chip pad 302 of the first control chip pad 301. In this way, the first functional pin 51, the second functional pin 52 and the first supporting pin 70 may be distributed evenly in the packaging body 10, so that supporting force of the first functional pin 51, the second functional pin 52 and the first supporting pin 70 on the power module 100 may be distributed evenly, so as to improve the reliability and stability of the power module 100.

In some embodiments, as shown in FIG. 19, the plurality of control pins 50 further include a third functional pin 53. The third functional pin 53 is electrically connected to the second control chip 32 and may be used to provide, for example, a high voltage to the second control chip 32.

In this case, as shown in FIGS. 7, 8, 13, and 17 to 21, the power module 100 further includes a second supporting pin 80 led out from the third side 10C of the packaging body 10 and only used to support the power module 100. The third functional pin 53 is connected with the second supporting pin 80 into a one-piece structure. Moreover, in the length direction X of the packaging body, the third functional pin 53 is located on a side of the second functional pin 52 away from the first functional pin 51 and proximate to a middle portion of the second side 10B of the packaging body 10. That is to say, the third functional pin 53 is disposed proximate to a middle position of the second control chip pad 302 of the first control chip pad 301.

In this way, the third functional pin 53 and the second supporting pin 80 may also support the power module 100 from two directions, so as to assist the first functional pin 51, the second functional pin 52 and the first supporting pin 70 in supporting the power module 100, so that the stability of the power module 100 may be further improved.

Moreover, the second supporting pin 80 is led out from the side of the power module extending in the width direction of the power module, which may avoid increasing the space of the power module 100 in the length direction X that is occupied by the second supporting pin 80, so that the volume of the power module 100 may be reduced and the miniaturization of the power module 100 may be further improved.

Meanwhile, in some examples, the third functional pin 53 may be connected with the second supporting pin 80 into a one-piece structure. It may be understood that the pin providing a high voltage to the control chip 30 is used, an end of the pin led out from the second side 10A of the packaging body 10 is used as a high-voltage pin (i.e., the third functional pin 53), and another end of the pin extending in the length direction X of the power module 100 and led out from the third side 10C of the packaging body 10 is used as a non-functional pin (i.e., the second supporting pin 80), and the non-functional pin and the high-voltage pin may support the power module 100 together. In this way, there is no need to add additional pins for supporting the power module, so that the miniaturization of the power module 100 may be further improved while the supporting stability of the power module is ensured.

In the power module 100 provided in some embodiments of the present disclosure, the power module 100 includes the second flow guide portion 1032 located at the corner of the end portion of the second side 10B of the packaging body 10 in the length direction X of the packaging body 10, and the second flow guide portion 1032 includes at least one concave portion. In this way, on the premise of ensuring that the packaging body 10 protects the main structure of the power module 100, not only the volume of the packaging body 10 may be reduced, the resin material required for packaging may be saved, and the production cost of the power module 100 may be reduced, but also the structure of the power module 100 may be compact, the volume of the power module 100 may be reduced, and the miniaturization of the power module 100 may be improved.

In a case where the second flow guide portion 1032 includes one concave portion, the first supporting pin 70 and the second supporting pin 80 are led out from a side of the concave portion extending in the width direction Y of the packaging body 10.

In a case where the second flow guide portion 1032 includes two continuous concave portions (i.e., the first concave portion 10321 and the second concave portion 10322), the entire first concave portion 10321 extends in the length direction X of the packaging body 10, and the entire second concave portion 10322 extends in the width direction Y of the packaging body 10. In this way, the production process of the packaging body 10 may be simplified and the production difficulty of the packaging body 10 may be reduced.

It may be seen that the second concave portion 10322 is farther away from the control pin 50 than the first concave portion 10321. Therefore, by making the first supporting pin 70 and the second supporting pin 80 led out from a side of the second concave portion 10322 extending in the width direction Y of the packaging body 10, not only the miniaturization of the power module may be improved, but also the insulation length between these pins may be extended.

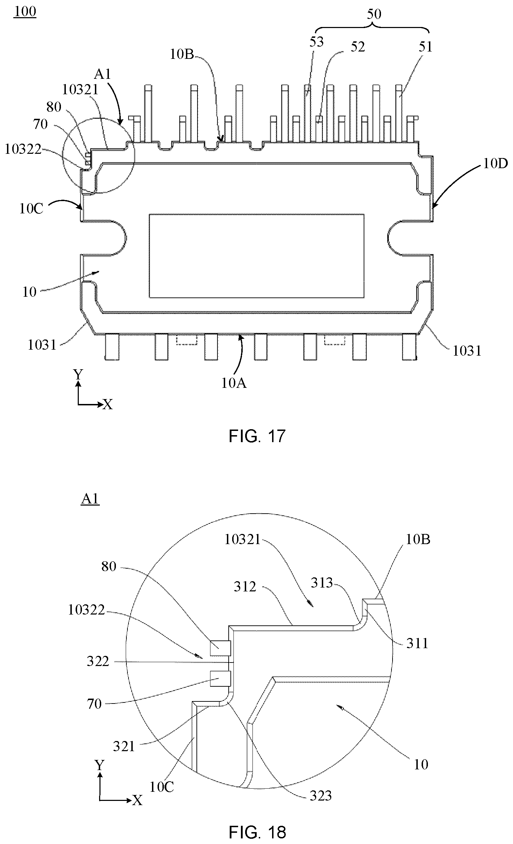

In addition, for example, as shown in FIGS. 17 and 18, lengths of the first supporting pin 70 and the second supporting pin 80 led out of the packaging body 10 do not exceed a depth of the second concave portion 10322. That is to say, in the length direction X of the packaging body 10, end portions of the first supporting pin 70 and the second supporting pin 80 led out of the packaging body 10 do not exceed the third side 10C of the packaging body 10. This not only increases a creepage distance between the first supporting pin 70 and its corresponding functional pin and a creepage distance between the second supporting pin 80 and its corresponding functional pin, but also avoids the electrical contact incidents or damage to the first supporting pin and the second supporting pin caused by the contact between the exposed first supporting pin 70 and second supporting pin 80 and the external devices located on a side of the third side 10C of the packaging body 10.

In some examples, as shown in FIG. 20, the first concave portion 10321 and the second concave portion 10322 are both in a shape of a long strip, and a length d1 of the first concave portion 10321 is greater than or equal to a length d2 of the second concave portion 10322. In this way, the shape design of the first concave portion 10321 and the second concave portion 10322 may be simplified, which may be conducive to molding the first concave portion 10321 and the second concave portion 10322, so that the production difficulty of the packaging body 10 may be further reduced.

Moreover, the lengths of the first concave portion 10321 and the second concave portion 10322 may be matched with the lengths of the first side 10A and the third side 10C where they are correspondingly located, respectively. As a result, the structural reliability of the power module 100 may be further improved on the premise of saving the resin material required for packaging and improving the compactness of the structure.

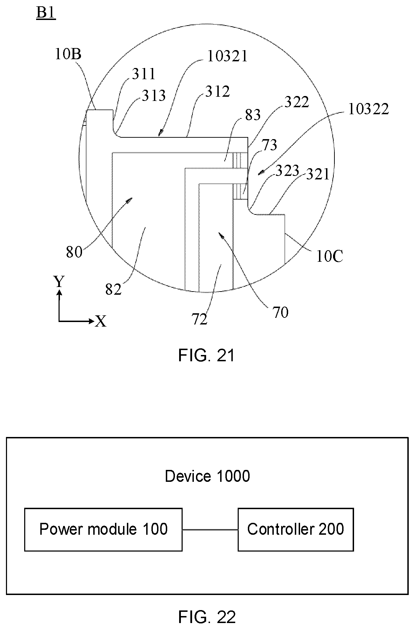

In the power module 100 provided in some embodiments of the present disclosure, as shown in FIGS. 18 and 21, the first concave portion 10321 includes a first sub-side 311 and a second sub-side 312. The first sub-side 311 extends in the width direction Y of the packaging body 10, and the second sub-side 312 extends in the length direction X of the packaging body 10. The first sub-side 311 is connected (e.g., may be vertically connected) between the second sub-side 312 and the second side 10B of the packaging body. A length (i.e., a dimension in the width direction Y of the packaging body 10) of the first sub-side 311 is less than a length (i.e., a dimension in the length direction X of the packaging body 10) of the second sub-side 312.

The second concave portion 10322 may mainly include a third sub-side 321 and a fourth sub-side 322. The third sub-side 321 extends in the length direction X of the packaging body 10, and the fourth sub-side 322 extends in the width direction Y of the packaging body 10. The third sub-side 321 is connected (e.g., may be vertically connected) between the fourth sub-side 322 and the third side 10C of the packaging body.

In this way, the structures of the first concave portion 10321 and the second concave portion 10322 may be simplified, so as to achieve the long strip structures of the first concave portion 10321 and the second concave portion 10322, and reduce the production difficulty of the second flow guide portion 1032.

For example, as shown in FIGS. 18 and 21, the first concave portion 10321 is further provided with a first transition arc surface 313 between the first sub-side 311 and the second sub-side 312. In this way, the stress distribution at the connection between the first sub-side 311 and the second sub-side 312 of the first concave portion 10321 may be even, so as to prevent the connection between the first sub-side 311 and the second sub-side 312 from breaking due to stress concentration, so that the fatigue safety coefficient of the packaging body 10 at the first concave portion 10321 may be improved, and the structural reliability of the packaging body 10 and even the power module 100 may be improved.

For example, as shown in FIGS. 18 and 21, the second concave portion 10322 is further provided with a second transition arc surface 323 between the third sub-side 321 and the fourth sub-side 322. In this way, the stress distribution at the connection between the third sub-side 321 and the fourth sub-side 322 of the second concave portion 10322 may be even, so as to prevent the connection between the third sub-side 321 and the fourth sub-side 322 from breaking due to stress concentration, so that the fatigue safety coefficient of the packaging body 10 at the second concave portion 10332 may be improved, and the structural reliability of the packaging body 10 and even the power module 100 may be improved.

In some embodiments, the first supporting pin 70 and the second supporting pin 80 may each include a first pin segment, a second pin segment, and a third pin segment connected in sequence.

As shown in FIG. 19, the first supporting pin 70 may include a first pin segment 71, a second pin segment 72 and a third pin segment 73 connected in sequence. The first pin segment 71 extends in the length direction X of the packaging body 10; the second pin segment 72 is connected to an end of the first pin segment 71 away from the second control chip 32, and extends in the width direction Y of the packaging body 10; the third pin segment 73 is connected to an end of the second pin segment 72 away from the first pin segment 71, and is bent and extends in the length direction X of the packaging body 10, and an end portion of the third pin segment 73 away from the second pin segment 72 is led out from the third side 10C (e.g., the fourth sub-side 322 of the second concave portion 10322) of the packaging body 10.

The second supporting pin 80 may include a first pin segment 81, a second pin segment 82 and a third pin segment 83 connected in sequence. The connection manner of the first pin segment 81, the second pin segment 82 and the third pin segment 83 of the second supporting pin 80 is similar to the connection manner of the first pin segment 71, the second pin segment 72 and the third pin segment 73 of the first supporting pin 70, and details will not be repeated herein.

In such arrangement, the first supporting pin 70 and the second supporting pin 80 may match the structure of the packaging body 10, which may not only ensure that the first supporting pin 70 and the second supporting pin 80 are led out from the third side 10C (e.g., the fourth sub-side 322 of the second concave portion 10322) of the packaging body 10 and ensure the supporting effect of the first supporting pin 70 and the second supporting pin 80 on the power module 100, but also may make the first supporting pin 70 and the second supporting pin 80 away from the screw fixing grooves on the power module 100 through their first pin segments and second pin segments, so as to avoid a problem that the electrical insulation requirement of the power module 100 cannot be ensured due to interference between the first supporting pin and second supporting pin and the screw fixing grooves or a short distance between the first supporting pin and second supporting pin and the screw, so that the reliability of the power module 100 may be improved.

In some examples, a width of the second pin segment 82 of the second supporting pin 80 is greater than a width of the second pin segment 72 of the first supporting pin 70 (i.e., dimensions in the length direction X of the packaging body 10).

In this way, the second pin segment 82 of the second supporting pin 80 and the second pin segment 72 of the first supporting pin 70 may make full use of the available space on the control chip pad 300, so as to enhance the structural stability of the second supporting pin 80 and the first supporting pin 70, thereby improving the stability of the supporting effect of the second supporting pin 80 and the first supporting pin 70 on the power module 100.

A device is further provided in some embodiments of the present disclosure, and the power module provided in the embodiments described above is applied to the device.

As shown in FIG. 22, the device 1000 includes a controller 200 and the power module 100 provided in any one of the embodiments, and the power module 100 is connected to the controller 200.

In some embodiments, there may be one or more power modules 100, and the device 1000 may include but is not limited to an inverter or a rectifier. For example, the device 1000 may be a motor drive controller.

For example, the controller 200 may generate a control signal according to a user instruction and send the control signal to the power module 100. The power module 100 generates a driving signal according to the control signal and outputs the driving signal to the corresponding driving component, so as to achieve driving control or inversion or rectification conversion.

By adopting the power module 100 of the embodiments described above, the insulation withstand voltage and insulation reliability of the device 1000 provided in the embodiments of the present disclosure are improved, and the electrical safety of the device is improved.

A person skilled in the art will understand that the scope of disclosure in the present disclosure is not limited to the specific embodiments described above, and may modify and substitute some elements of the embodiments without departing from the concept of present disclosure. The scope of the present disclosure is limited by the appended claims.

## Claims

1. A power module, comprising:
a packaging body;
a power chip disposed in the packaging body;
a control chip disposed in the packaging body and electrically connected to the power chip;
a power pin led out from a first side of the packaging body, the power pin being electrically connected to the power chip; and
a control pin led out from a second side of the packaging body, the first side and the second side being disposed opposite to each other, and the control pin being electrically connected to the control chip; wherein
the packaging body includes a flow guide portion located at at least one corner of the packaging body, and the flow guide portion is configured to guide a resin to flow, so as to avoid a gap at the corner in the packaging body.

2. The power module according to claim 1, wherein the flow guide portion includes a first flow guide portion located at a corner of an end portion of the first side of the packaging body in a length direction of the packaging body; and/or
the flow guide portion includes a second flow guide portion located at a corner of an end portion of the second side of the packaging body in the length direction of the packaging body.

3. The power module according to claim 2, wherein in a case where the flow guide portion includes the first flow guide portion, the first flow guide portion includes a chamfer or a convex portion; and/or
in a case where the flow guide portion includes the second flow guide portion, the second flow guide portion includes a chamfer, a convex portion, or at least one concave portion.

4. The power module according to any one of claims 1 to 3, wherein the packaging body further includes a first step portion located on a side of a portion of the power pin extending out of the packaging body, and the side of the portion is proximate to a bottom surface of the packaging body; wherein
the first step portion has a step surface and a side; in a width direction of the packaging body, the side of the first step portion is closer to a center of the packaging body than the first side of the packaging body; and in a thickness direction of the packaging body, the step surface of the first step portion is closer to the center of the packaging body than the bottom surface of the packaging body.

5. The power module according to claim **4,** wherein the first step portion includes a main body portion extending in a length direction of the packaging body and an end portion extending in the width direction of the packaging body; wherein
the first step portion further includes a third flow guide portion connecting the main body portion and the end portion of the first step portion.

6. The power module according to claim 5, wherein the third flow guide portion includes a chamfer or a convex portion.

7. The power module according to any one of claims 1 to 6, wherein the packaging body further includes a second step portion located on a side of a portion of the control pin extending out of the packaging body, and the side of the portion is proximate to a bottom surface of the packaging body; wherein
the second step portion has a step surface and a side; in a width direction of the packaging body, the side of the second step portion is closer to a center of the packaging body than the second side of the packaging body; and in a thickness direction of the packaging body, the step surface of the second step portion is closer to the center of the packaging body than the bottom surface of the packaging body.

8. The power module according to claim 7, wherein the second step portion includes a main body portion extending in a length direction of the packaging body and an end portion extending in the width direction of the packaging body; wherein
the second step portion further includes a fourth flow guide portion connecting the main body portion and the end portion of the second step portion.

9. The power module according to claim 8, wherein the fourth flow guide portion includes a chamfer, a convex portion or a concave portion.

10. The power module according to any one of claims 1 to 9, wherein the packaging body further includes a third step portion located on a side of a portion of the control pin extending out of the packaging body, and the side of the portion is away from a bottom surface of the packaging body; wherein
the third step portion has a step surface and a side; in a width direction of the packaging body, the side of the third step portion is closer to a center of the packaging body than the second side of the packaging body; and in a thickness direction of the packaging body, the step surface of the third step portion is closer to the center of the packaging body than a top surface of the packaging body.

11. The power module according to claim 10, wherein the third step portion includes a main body portion extending in a length direction of the packaging body and an end portion extending in the width direction of the packaging body; wherein
the third step portion further includes a fifth flow guide portion connecting the main body portion and the end portion of the third step portion.

12. The power module according to claim 11, wherein the fifth flow guide portion includes a chamfer, a convex portion or a concave portion.

13. The power module according to any one of claims 1 to 12, further comprising:
a control chip pad for mounting the control chip;
at least one bootstrap chip disposed in the packaging body;
at least one bootstrap chip pad for mounting the at least one bootstrap chip, the at least one bootstrap chip pad and the control chip pad being arranged at an interval; wherein the bootstrap chip pad includes a partition portion, and a chip soldering portion and a trace connecting portion located on two sides of the partition portion, respectively, and the bootstrap chip is disposed in a chip soldering region; and
at least one trace configured to electrically connect the control chip and the trace connecting portion of the bootstrap chip pad.

14. The power module according to claim 13, wherein the partition portion is a groove in a shape of a strip.

15. The power module according to claim 13 or 14, wherein the control chip pad and the bootstrap chip pad are arranged at an interval in a width direction of the power module, and the partition portion extends in the width direction of the power module.

16. The power module according to any one of claims 13 to 15, wherein the power module comprises a plurality of bootstrap chip pads, and the plurality of bootstrap chip pads are arranged at intervals in a length direction of the power module; wherein
in the length direction of the power module, the trace connecting portion included in a bootstrap chip pad of the plurality of bootstrap chip pads located at at least one end is closer to the control chip than the chip soldering portion included in the bootstrap chip pad.

17. The power module according to any one of claims 13 to 16, wherein a through hole is disposed on the chip soldering portion, and the through hole is located on a side of the bootstrap chip mounted on the chip soldering portion away from the control chip.

18. The power module according to any one of claims 1 to 17, further comprising:
a first supporting pin extending from a third side of the packaging body adjacent to the second side; wherein
the control pin includes a first functional pin and a second functional pin; in a length direction of the packaging body, the second functional pin is proximate to a middle portion of the second side, and the first functional pin is located on a side of the second functional pin away from the first supporting pin; and
the first functional pin, the second functional pin, and the first supporting pin are configured to support the power module from different sides of the power module.

19. The power module according to claim 18, further comprising:
a control chip pad for mounting the control chip; wherein the first functional pin, the second functional pin and the first supporting pin are connected with the control chip pad into a one-piece structure; and
a second supporting pin led out from the third side; wherein
the control pin further includes a third functional pin, and in the length direction of the packaging body, the third functional pin is located on a side of the second functional pin away from the first functional pin and proximate to the middle portion of the second side; wherein
the second supporting pin is connected with the third functional pin into a one-piece structure.

20. The power module according to claim 19, wherein in a case where the power module further comprises a second flow guide portion located at a corner of an end portion of the second side of the packaging body in the length direction of the packaging body,
the second flow guide portion includes a concave portion, and the first supporting pin and the second supporting pin are led out from the concave portion; or
the second flow guide portion includes a first concave portion and a second concave portion that are two continuous concave portions, the first concave portion extends in the length direction of the packaging body, and the second concave portion extends in a width direction of the packaging body; the first supporting pin and the second supporting pin are both led out from the second concave portion.

21. The power module according to claim 19 or 20, wherein the first supporting pin and the second supporting pin each include a first pin segment, a second pin segment and a third pin segment connected in sequence; the first pin segment extends in the length direction of the packaging body, the second pin segment extends in the width direction of the packaging body, and the third pin segment extends in the length direction of the packaging body and extends out of the packaging body from the third side of the packaging body.

22. A device comprising a controller and the power module according to any one of claims 1 to 21, the power module being connected to the controller.
